# EUROPEAN PATENT SPECIFICATION

(11) **EP 2 659 280 B1**
(45) Date of publication and mention of the grant of the patent: **17.04.2019**
(21) Application number: 11830087.0
(22) Date of filing: 27.12.2011
(51) Int. Cl.: G01R 33/565, G01R 33/56

(54) **METHOD FOR ELIMINATING PHASE ENCODING ARTIFACTS FROM A MAGNETIC RESONANCE IMAGE**
VERFAHREN ZUR ENTFERNUNG VON PHASENKODIER-ARTEFAKTEN AUS EINEM MAGNETRESONANZBILD
PROCÉDÉ POUR ÉLIMINER DES ARTÉFACTS DE CODAGE DE PHASE D'UNE IMAGE PAR RÉSONANCE MAGNÉTIQUE

(30) Priority: 28.12.2010 IT PI20100142
(43) Date of publication of application: 06.11.2013
(73) Proprietor: Dell'Orso, Andrea, 56036 Poggibonsi (SI) (IT)
(72) Inventor: Dell'Orso, Andrea, 56036 Poggibonsi (SI) (IT)
(74) Representative: Celestino, Marco
(86) International application number: PCT/IB2011/055977
(87) International publication number: WO 2012/090162

(56) References cited:
- US-A1- 2003 102 864
- US-A1- 2010 164 493
- MACLAREN J R ET AL: "MRI with TRELLIS: a novel approach to motion correction", MAGNETIC RESONANCE IMAGING, ELSEVIER SCIENCE, TARRYTOWN, NY, US, vol. 26, no. 4, 1 May 2008 (2008-05-01), pages 474-483, XP022609803, ISSN: 0730-725X, DOI: DOI:10.1016/J.MRI.2007.08.013 [retrieved on 2008-02-20]
- HAIFENG WANG ET AL: "Cross-sampled GRAPPA for parallel MRI", 2010 32ND ANNUAL INTERNATIONAL CONFERENCE OF THE IEEE ENGINEERING IN MEDICINE AND BIOLOGY SOCIETY (EMBC 2010) IEEE PISCATAWAY, NJ, USA, 31 August 2010 (2010-08-31), pages 3325-3328, XP002646201, ISBN: 978-1-4244-4123-5

## Description

### Field of the invention

The present invention relates to the field of processing magnetic resonance images for eliminating phase coding artifacts produced by noise, by small movements of the patient who is under magnetic resonance analysis, or due by natural physiological activity of an examined anatomical part, or further by problems due to signal sampling.

### Description of the prior art

As well known, with the term "artifact" a noise is indicated, i.e. an imperfection, or characteristic, which appears in a magnetic resonance image, which, however, is not present in the patient under the examination, or in case of diagnostic images, in the examined anatomical part.

The artifact is, sometimes, the result of a malfunction of the apparatus, or in other cases is the consequence of natural activities of determined anatomical parts of the human body. In any case, the appearance of artifacts in an image can affect the correct examination of the examined anatomical part and leads to a wrong diagnosis, for example hiding a disease.

Normally the artifacts are classified according to the cause that produces them. For example, the "artifacts from movement" are those produced by the movement of the anatomical part examined during the imaging sequence. Such movement of the whole target during the imaging sequence normally causes an obscuration of the whole image by one, or more "ghost images", or simply "ghost". A solution for avoiding an artifact due to movement is to immobilize the patient, or the examined object. Different techniques exist for correcting at least in part the artifacts due to movement.

The movement of a small portion of the examined object causes, instead, the obscuration in the image of the same portion of the anatomical part. For example, "ghost" images can be produced by the pulsating movement of a blood vessel. These artifacts are known as "artifacts due to flow" and are caused by the flow of the blood, or of other liquids, through the body. The flow of a liquid through a "layer", i.e. a cross section of the body, can meet a radio frequency pulse (RF) which van exit from the corresponding layer when the signal is recorded.

Another type of very common artifacts in the magnetic resonance images are due to reprojection, or "aliasing" artifact. Such type of artifacts consists of reprojection of the parts of the image that are external to the Field Of View, or FOV, and it occurs when the field of view in the phase coding direction is smaller than the object that has to be displayed. For this reason the aliasing artifact is compared to the phase coding artifacts direction.

Other phase coding artifacts can be caused by small tremors of the subject during the examination, involuntary contractions of anatomical parts owing to the duration of the examination, the flow of blood through a vessel, e.g. the aorta, the presence of water, the difference of intensity of a part of the image with respect to adjacent areas.

In all the above described cases, the artifacts propagate along two directions, and precisely along a horizontal direction of the image, when the phase coding is made along rows, and along a vertical direction of the image, when the phase coding is made along columns. The phase coding artifacts propagate, in fact, along the rows and the columns of the matrix structure in which the pixels of the image are arranged. The propagation direction of the artifacts along rows or columns, therefore, depends on the parameter "PHASE CODING DIRECTION" that is set in the software by the operator of the apparatus before starting the acquisition sequence. When a phase coding acquisition along rows is chosen, the artifact propagates mainly in the image along one, or more, rows. If, instead, a phase coding acquisition along columns is chosen, the artifact mainly propagates in the image along one, or more, columns. The artifacts are, therefore, visible along the phase coding direction and appear as imperfections, fuzziness, or shadings of determined regions of the image. The presence of artifacts in a magnetic resonance image can compromise the result of the examination and induces, therefore, the physician to make a wrong diagnosis.

Different techniques exist to limit the effects of noise, i.e. artifacts on a magnetic resonance image.

A first technique consists of adjusting the operative parameters of the magnetic resonance machine in order to try to attenuate the presence of the artifacts on the image. For example, the operator, depending on the situations, can apply filters, or increase, or reduce, the contrast, or the brightness of the pixels. These techniques, however, bring to "alter" the final image and therefore it is possible to hide, together with the artifact, a possible disease indicator of the examined subject. Furthermore, this type of approach can be carried out only by operators having a consolidated experience and is delegated to the sensitivity and to the personal capacity of the operators.

With the above described techniques it is not possible, in any case, to completely eliminate an artifact from a magnetic resonance image. What can be obtained is to establish the direction of propagation of the artifacts in such a way that they disturb the image as little as possible.

Another technique used for trying to limit the effects of the artifacts on the magnetic resonance images consists of applying a saturation band, or a pre-saturation band, on one, or more regions of a reference image arranged outside the anatomical part of interest, or in any case considered to be of little relevance for carrying out the examination and responsible to the generation of artifacts. In practice, the operator arranges in the reference image, e.g. a "scout" image, or a "survey" image, one, or more dark bands at the regions that can be subjected to noise. This way, when the acquisition sequence of the images is started, usually at least one image with phase coding along rows, or at least one image with phase coding along columns, the signals deriving from the regions occupied by the bands are excluded from the construction process of the same images.

However, this technique has some drawbacks. Firstly, the shape of the saturation bands, that is usually rectangular, cannot be modified in order to adapt them to the shape of a determined region, but can only be reduced, or enlarged in size. Therefore, on the one hand the correct arrangement of the saturation band is extremely complicated and, on the other hand, covering a region of irregular shape causes the need to use a high number of bands with a great loss of time for the operator and an increase of the time necessary to the machine to complete the image sequence. Furthermore, the saturation band can be located at an anatomical part affected by a disease that therefore would be impossible to diagnose.

Finally, excluding determined regions from the resonance image and normally almost all the regions external to the anatomical part of interest, it is impossible to have collateral reports, i.e. to accidentally diagnose the presence of a disease that affects an anatomical part different from the main object.

In US2003/102864 a method is described for elaborating magnetic resonance images, comprising an acquisition step of a first series of data of a first k-space and of a second plurality of data of a second k-space of the same subject. The method comprises, furthermore, a computation step of the phase differences between the two series of k-spaces and a successive computation step of the corrections to apply for the movement of the subject using the series of data related to the phase difference of the two k-spaces. More precisely, the computation step of the corrections is obtained by solving a set of simultaneous linear equations that describes the phase changes caused by the movement of the subject. At last, the phase corrections calculated as above described, are applied to the series of data of the first k-space. Therefore, the method described in US2003/102864 is considerably complex and implies long time for controlling the data.

### Summary of the invention

It is therefore a feature of the present invention to provide a method for eliminating phase coding artifacts from a magnetic resonance image.

It is also a feature of the present invention to provide a method for eliminating artifacts from a magnetic resonance image, for example a diagnostic image, which makes it possible to obtain magnetic resonance images with high definition.

It is a particular feature of the present invention to provide a method for eliminating artifacts from a magnetic resonance image, for example a diagnostic image, which assists and speeds up the acquisition sequence of magnetic resonance images, in particular eliminating the need to set the parameter "phase coding direction" by the operator.

It is another particular feature of the present invention to provide a method for eliminating artifacts from a magnetic resonance image, for example a diagnostic image, which can be implemented both in existing machines of magnetic resonance and in new machines.

It is a further particular feature of the present invention to provide a method for eliminating artifacts due to reprojection, or tilting, or "aliasing".

These and other features are accomplished with one exemplary method, according to the invention, for eliminating artifacts from a magnetic resonance image, in particular a diagnostic image, comprising the steps of:
- obtaining a first image through a predetermined data acquisition sequence and using a phase coding along columns, said first image comprising a plurality of portions, each portion arranged in a matrix structure (m·n), comprising m rows and n columns, each portion of said plurality being associated to a brightness intensity value *i*₁ calculated making the arithmetic average, or the weighted average, of the intensity values of the pixels that compose said portion;
- obtaining a second image through said measured acquisition sequence used to obtain said first image, but using a phase coding along rows, said second image comprising a plurality of portions, each portion arranged in a matrix structure of (m-n)pixels having m rows and n columns, each portion of said plurality being associated to a brightness intensity value i 2 calculated making the arithmetic average, or the weighted average, of the brightness intensity values of the pixels that compose said portion;
- applying a processing sequence to said first and to said second image, said processing sequence comprising the steps of:
   - analysing by columns said first and said second image, by a comparative analysis by columns of at least one column of said first image with a corresponding column of said second image and calculating, among said corresponding columns, the number of different portions, i.e. portions having different brightness intensity values (i₁≠i₂);
   - creating a first derived image obtained from one among said first and second images, by replacing said, or each, column of said first or second image with the corresponding column of said second or first image if the number of different portions, between said first and second images, for a respective analysed column, is higher, or equal, to a predetermined threshold value *k1,* with *k1*=1...*n*;
   - repeating said step of analysing by columns for all the columns of said first and second images, obtaining a first derived image of I generation;
   - analysing by rows said first and second images, by a comparative analysis by rows of at least one row of said second image with a corresponding row of said first image, and calculating between said corresponding rows the number of different portions, i.e. portions having different brightness intensity values (iᵢ≠i₂);
   - creating a second derived image obtained from one among said second and said first image, by replacing said, or each, row of said second or first image with the corresponding row of said first or second image, respectively, if the number of portions having different brightness intensity values between said first and second images, for a respective analysed row, is higher, or equal, to a predetermined threshold value *k2*, with *k2*=1...m;
   - repeating said analysis by rows for all the rows of said images, obtaining a second derived image of I generation;
- subjecting the first and the second derived image of I generation to a further processing step obtaining a first and a second derived image of II generation, said further processing step being carried out subjecting to an analysis by columns the derived image of I generation obtained by an analysis by rows, and to an analysis by rows the derived image of I generation obtained by an analysis by columns, and subtracting 1 from the threshold value k1, or k2, used during the previous step of comparative analysis carried out by rows, or by columns, using as threshold values k1'=k1-1 and k2'=k2-1, obtaining an improved image;
- said comparative analysis by columns and said comparative analysis by rows consisting in a comparison of the brightness intensity values of the respective portions occupying the same positions in said first and in said second image, said comparison of the brightness intensity values being carried out considering the brightness intensity values of the two respective portions to be equal if said difference of brightness intensity values of two respective portions is less than a predetermined reference value Δi* and, instead, considering the brightness intensity values of the two portions to be different if said difference of brightness intensity values of the two respective portions is higher than the predetermined reference value Δi*.

In particular, with intensity value i an intensity value of signal, or an intensity value of colour, for example in gray scale, can be intended. In the latter case the intensity value can be, for example, set between 0, corresponding to the black colour, and 255, corresponding to the white colour. In particular, the comparative analysis by columns and the comparative analysis by rows consists of a comparison of the intensity values of the respective homologous portions, i.e. of the portions that take the same positions in the first and in the second image. More in detail, if the difference of intensity value of two homologous portions is less than a predetermined threshold value Δi*, the intensity values of the two homologous portions are considered to be equal to each other, whereas if the difference of intensity values of the two homologous portions is higher than the reference value Δi*, the intensity values of the two homologous portions are considered to be different from each other.

Advantageously, a step is also provided of computing the difference between the intensity values of the portions of a same row and/or of a same column. In particular, if the difference of the intensity values of at least two portions of a same row, or of a same column, of a same image is less than a predetermined threshold value Δiₗᵢₘ a supplementary control step is provided for verifying that it is not a portion of a row, or of a column, along which the artifact propagates. In fact, notwithstanding it is unlikely, however, it is possible that a situation occurs in which, in the image obtained by rows the artifact propagates, mainly, along one, or more, columns, or in the image obtained by columns the artifact propagates, mainly, along one, or more, rows.

In particular, the reference value Δi* and/or the reference value Δiₗᵢₘ is preliminarily chosen by an operator.

Advantageously, the reference value Δi* and/or the reference value Δiₗᵢₘ is a default value.

In particular, each portion of the plurality of portions comprises a plurality of pixels, each pixel of the plurality of pixels being associated with a determined brightness value i. Therefore, in this case a step is provided of computing an average value *i*ₘ of the brightness values of the plurality of pixels that compose each portion, said average value *i*ₘ being used for said comparative analysis by rows and for said comparative analysis by columns.

Advantageously, furthermore, a step is provided for preparing a final image comprising the steps of:
- computing the average intensity value *i*m* of intensity values *i*ₘ₁ and *i*ₘ₂ of each couple of homologous portions, i.e. occupying a same position in the first derived image and in the second derived image;
- associating to a portion of said final image that occupies a predetermined position, the average intensity value Iₘ* of the couple of homologous portions that occupy the same positions in said first and in said second derived image, respectively.

In particular, the first and second images are obtained using a same acquisition sequence and using the same instrumental variables of the machine such as the repetition time (TR), the echo time (TE), the inversion time (TI), the nutation angle (θ) or "flip angle", the size of the pixels, the Field Of View, or FOV, the layer thickness, the "window" (W), the "level" (L), with the first image with a phase coding along rows and the second image with a phase coding along columns, or vice-versa.

Advantageously, each portion of said plurality of portions into which is divided each of said first and second images comprises a predetermined number of pixels, each pixel having a determined intensity value i.

In this case, the average intensity value *i*₁ₘ, or i₂ₘ, can be the arithmetic average of the intensity values of the pixels that compose a predetermined portion. Alternatively, the average intensity value *i*₁ₘ, or i₂ₘ, can be a weighted average of the intensity values of the pixels.

In an exemplary embodiment, each portion of image comprises a single pixel having a determined intensity value i. In this case, therefore, the average intensity value *i*₁ₘ, or *i*₂ₘ, of a predetermined portion coincides with the I value of the pixels.

In particular, the number of rows m can be selected from the group consisting of:
- 128;
- 256;
- 512;
- 1024;
- 2048.

In particular, the number of columns n can be selected from the group consisting of:
- 128;
- 256;
- 512;
- 1024;
- 2048.

For example, the first and the second images are magnetic resonance images and have a square size selected from the group consisting of:
- 128x128 pixels;
- 256x256 pixels;
- 512x512 pixels;
- 1024x1024 pixels.

The above described combination of the first and second derived images of I generation is obtained subjecting the first and the second derived image of I generation to a further processing step obtaining a first and a second derived image of II generation. In fact, it is possible that at the end of the first processing step, the images of I generation can be improved further, since the k value, i.e. the number of different pixels, could still not be =0.

In particular, the further processing step is carried out subjecting to an analysis by columns the derived image of I generation obtained by an analysis by rows, and to an analysis by rows the derived image of I generation obtained by an analysis by columns, and subtracting 1 from the threshold value *k1,* or *k2,* used during the previous step of comparative analysis carried out by rows, or by columns, i.e. using as threshold values k1'=k1-1 and k2'=k2-1. If the same value of k is used as the previous comparative analysis, in fact, the image is not computed further and therefore it is not possible to further "improve" it. Instead, if a value of k is used that is less than one unit with respect to the value of the previous comparative analysis, i.e. k1'<k1-1, a tilting of the image can be caused.

Alternatively, the above described combination of the first and second images is obtained computing the average of the intensity values of the homologous portions.

The method can, furthermore, provide a preliminary step of division of an image obtained by a phase coding along rows and of an image obtained by a phase coding along columns in a plurality of portions having the above described matrix structure (m·n), i.e. comprising m rows and n columns. In particular, each portion of the matrix structure comprises a predetermined number of pixels, each of which associated with an intensity value i. Therefore, each portion is associated with an intensity value that is computed on the basis of the intensity values of the pixels that compose it, for example computed as an arithmetic average.

In particular, the processing sequence can comprise a plurality of processing steps, said processing sequence stopping when at least one among said threshold value *k1,* or k2, that is used for carrying out said analysis by rows, or said analysis by columns, is equal to 0.

In particular, *k*1 can be set between 0 and n, advantageously between 2 and n.

In particular, *k₂* can be set between 0 and m, advantageously between 2 and m.

Preferably, the threshold value *k₁* that is used in the analysis by columns coincides with the threshold value *k₂* that is used in the analysis by rows, i.e. *k₁*=*k₂*=*k*.

In particular, the threshold value k can be computed through the steps of:
- analysing by columns said first and second images;
- computing a number s of different portions between at least one column of the first image and a corresponding column of the second image;
- identifying a maximum number *sₘₐₓ* between all the different numbers s of all the couples of analysed columns;
- analysing by rows said first and second images;
- computing a number r of different portions between a determined row of the first image and the corresponding row of the second image;
- defining a maximum number *rₘₐₓ* between all the different numbers r of all the couples of analysed rows;
- associating the higher value between the computed number *sₘₐₓ* and the computed number *rₘₐₓ* at said threshold value k.

In an exemplary embodiment of the invention, it is possible to start from four images of the anatomical part to be examined, said four images being obtained using a same acquisition sequence and same instrumental variables for each image that is obtained. More in detail, two of the four images to be examined are obtained using a phase coding along rows and the other two using a phase coding along columns. Therefore, in this case, two couples of images are obtained each of which comprises an image that is obtained using a phase coding along rows and an image obtained using a phase coding along columns.

In this case, the method for eliminating the artifact from an image provides to subject each couple of images to the above described steps. More precisely, through the processing step of the first couple of images a first improved image is obtained and through the processing step of the second couple of images a second improved image is obtained. In this case, the first and the second improved images are subject to a further step of computing the average value of the intensity i of the respective homologous portions. This way, a final image having a high definition is obtained of the anatomical part to be examined.

Normally, it is possible to subject to a processing sequence as above described a desired combination of the four starting images provided that an image is obtained by a phase coding along rows and an image is obtained by a phase coding along columns.

Similarly, it is possible to subject to the processing steps above described a desired number of couples of starting images, each couple of images comprising an image obtained using a phase coding along rows and an image obtained using a phase coding along columns and computing the average Im* of the intensity values I of the homologous portions.

The method according to the invention can be also used for correcting, or fully eliminating, an "aliasing" artifact, i.e. an artifact obtained by a "reprojection" of parts, for example anatomical parts, arranged outside the field of view, or "FOV", of the image. Such type of artifact occurs when the field of view in the direction of the phase coding has a size that is less than the displayed object. An "aliasing" artifact is produced, for example, when for evaluating in detail the anatomical part of interest it is necessary to enlarge a predetermined region of a reference image. Similarly, there is an "aliasing" artifact when the region of interest of the image is only a predetermined part of the examination plane of the anatomical part subject to magnetic resonance. The method can also be applied to diagnostic images that, in addition to a traditional artifact, comprises also an "aliasing" artifact.

In this case, the portions, i.e. the columns and/or the rows, not belonging to the region of interest produce the artifact. More precisely, in the image obtained by a phase coding along rows there is an artifact due to a reprojection of the columns not belonging to the region of interest. Similarly, in the image obtained by a phase coding along columns there is an artifact due to a reprojection of the rows not belonging to the region of interest.

In this case, the final image is obtained applying a secondary processing sequence:
- analysing by columns said first and second images, by a comparative analysis by columns of at least one column of said first image with a corresponding column of said second image, and calculating the number of different portions, i.e. portions having different intensity values between said corresponding columns;
- creating a first derived image obtained from said second image, by replacing said, or each, column of said second image with the corresponding column of said first image, if the number of different portions between said first and second images, for a respective analysed column, is higher, or equal, to a predetermined threshold value *k₁*, with *k₁*=1...n;
- repeating said step of analysing by columns for all the columns of said first and second images obtaining a first derived image of I generation;
- analysing by rows said first and second images, by a comparative analysis by rows of at least one row of said second image with a corresponding row of said first image and calculating between said corresponding rows the number of different portions, i.e. having a different intensity value;
- creating a second derived image obtained from said first image, by replacing said, or each, row of said first image with the corresponding row of said second image, if the number of different portions between said first and second images, for a respective analysed row, is higher, or equal, to a predetermined threshold value *k₂*, with *k2*=1...m;
- repeating said analysis by rows for all the rows of said images, obtaining a second derived image of I generation.

Alternatively, the final image is obtained through the steps of:
- selecting a region of interest in a reference image, said reference image comprising a predetermined number of rows m and a predetermined number of columns n, said region of interest comprising a predetermined number of rows m', with m'<m, and a predetermined number of columns n', with n'<n;
- obtaining a first image of said region of interest, said first image being obtained through a predetermined acquisition sequence and using a phase coding along columns, said first image comprising a plurality of portions having a matrix structure (m"·n"), i.e. having m" rows and n" columns, each portion having a determined intensity value *i*;
- obtaining a second image of said region of interest, said second image being obtained through said determined acquisition sequence used to obtain said first image, but using a phase coding along rows, said second image comprising a plurality of portions having a matrix structure (m"·n"), i.e. having m" rows and n" columns, each portion having a determined intensity value *i*;
- computing an enlargement factor *r with* r=m"/m'=n"/n';
- defining a first working area in said first image, said first working area being obtained multiplying by said enlargement factor r the number of rows of said reference image that are arranged outside said region of interest and subtracting the number of rows thus obtained from said first image, said subtracting step carried out in a position that is symmetric, with respect to a horizontal axis, to the position occupied by said excluded rows in said reference image, such that the rows that in the reference image are excluded above are multiplied by the enlargement factor and, then subtracted from the first image starting from below, and analogously the rows in the reference image are excluded below are multiplied by the enlargement factor and then subtracted from the first image starting from the above;
- defining a second working area in said second image, said second working area being obtained multiplying the number of columns of said reference image that are arranged outside said region of interest by said enlargement factor r and subtracting the number of columns thus obtained from said second image, said subtracting step carried out in a position symmetric with respect to a vertical axis to the position occupied in the reference image by said excluded columns, such that the columns that in the reference image are excluded on the right side are multiplied by the enlargement factor and then subtracted from the second image starting from the left side, and analogously the columns that in the reference image are excluded at the left side are multiplied by the enlargement factor and then subtracted from the second image starting from the right side;
- creating a final image, in said final image said first working area of said first image and said second working area of said second image being reproduced "as such", said first and second areas comprising a common region, i.e. comprising a plurality of portions that occupy the same position, said common region being reproduced in said final image only once, taking it from said first image, or from said second image;

- defining end regions in said first and in said second image, said end regions belonging neither to the first nor to the second working area;
- applying said secondary processing sequence to the homologous end regions of said first image obtained by columns and of said second image obtained by rows.

In particular, the secondary processing sequence can comprise a plurality of secondary control steps, said secondary processing sequence stopping when at least one among said threshold value *k₁,* or *k₂*, used for carrying out said analysis by rows, or said analysis by columns, is equal to 0. In this case also it is possible to have *k₁*=*k₂*=k.

Advantageously, the further steps are provided of:
- defining the common, or intersection, region between the first working area and the second working area;
- applying a primary processing sequence to said intersection region obtaining a final working area, said primary processing sequence comprising the steps of:
   - analysing by columns said first and second images, by a comparative analysis by columns of at least one column of said first image with a corresponding column of said second image, and calculating among corresponding columns the number of different portions, i.e. having a different intensity value;

   - creating a first derived image obtained by said first image, by replacing said, or each, column of said first image with the corresponding column of said second image if the number of different portions between said first and second images, for a respective analysed column, is higher, or equal, to a predetermined threshold value *k₁,* with *k₁*=1...n;
   - repeating said step of analysing by columns for all the columns of said first and second images obtaining a first derived image of I generation;
   - analysing by rows said first and second images, by a comparative analysis by rows of at least one row of said second image with a corresponding row of said first image and calculating the number of different portions, i.e. having a different intensity value, between corresponding rows;
   - creating a second derived image obtained by said second image, by replacing said, or each, row of said second image with the corresponding row of said first image if the number of different portions between said first and second images, for a respective analysed row, is higher, or equal, to a predetermined threshold value *k₂*, with *k2*=1...m;
   - repeating said analysis by rows for all the rows of said images, obtaining a second derived image of I generation;
   - obtaining an image selected from the group consisting of:
      - said first derived image of I generation;
      - said second derived image of I generation;
      - a combination of said first and second derived images of I generation.

In particular, the primary processing sequence can comprise a plurality of secondary processing steps, said secondary processing sequence stopping when at least one among said threshold value *k₁*, or *k₂*, used for carrying out said analysis by rows, or said analysis by columns, is equal to 0. Even in this case it is *k₁*=*k₂*=k.

In an exemplary embodiment of the invention before the processing step, the first and second images to be examined are subject to a preliminary identification step for detecting the propagation direction of the artifact. In particular, in the preliminary identification step it can be verified that the, or each, artifact that is present in the image obtained by a phase coding along rows propagates mainly along one, or more, rows and that the, or each, artifact that is present in the image obtained by a phase coding along columns propagates mainly along one, or more, columns. If the verification has a negative result, i.e. the artifact that is present in the image obtained by a phase coding along rows propagates mainly along one, or more, columns and the artifact that is present in the image obtained by a phase coding along columns propagates mainly along one, or more, rows, the first and second images are subject to an analysis by rows and to an analysis by columns, as above described, but exchanging the first image with the second image before starting the controlling step.

The method according to the invention can be also applied for correcting, or eliminating, "wrap around" artifact, or undersampling. In this case, the processing sequence provides the steps of:
- analysing by columns said first and second images, by a comparative analysis by columns of at least one column of said first image with a corresponding column of said second image, and calculating the number of different portions between corresponding columns, i.e. having a different intensity value;
- creating a first derived image obtained by said second image, by replacing said, or each, column of said second image with the corresponding column of said first image if the number of different portions between said first and second images, for a respective analysed column, is higher, or equal, to a predetermined threshold value *k₁,* with *k₁*=1...n;
- repeating said step of analysing by columns for all the columns of said first and second images, obtaining a first derived image of I generation;
- analysing by rows said first and second images, by a comparative analysis by rows of at least one row of said second image with a corresponding row of said first image and calculating the number of different portions between corresponding rows, i.e. having a different intensity value;
- creating a second derived image obtained by said first image, by replacing said, or each, row of said first image with the corresponding row of said second image if the number of different portions between said first and second images, for a respective analysed row, is higher, or equal, to a predetermined threshold value *k₂*, with *k₂*=1...m;
- repeating said analysis by rows for all the rows of said images, obtaining a second derived image of I generation.

Notwithstanding in the present text reference is made to a first image and to a second image, the words "first" and "second" are not to be interpreted as a temporal order.

Normally, it is intended that in a substantially sagittal image the columns are orientated along a "head-feet" direction and the rows along an "front-rear" direction. In a substantially coronal image the columns are orientated along a "head-feet" direction and the rows along a "right-left" direction. In a substantially axial image the columns are orientated along a "front-rear" direction and the rows along a "right-left" direction.

### Brief description of the drawings

The invention will be now shown with the following description of an exemplary embodiment thereof, exemplifying but not limitative, with reference to the attached drawings in which:
- Fig. 1 diagrammatically shows in a perspective view a preliminary phase of the method according to the invention, for eliminating phase coding artifacts from a magnetic resonance image;
- Figs. from 2 to 8 diagrammatically show some steps of a first exemplary embodiment of the method according to the invention;

- Fig. 9 shows in a flow-sheet representation the main phases provided by the method according to the invention, through which it is possible to calculate the threshold value;
- Fig. 10 diagrammatically shows the starting images where the method according to the invention is applied to four magnetic resonance images, two of which obtained by a phase coding along rows and two with phase coding along columns;
- Figs. from 11 to 19 diagrammatically show some possible steps of the method if the artifact to be eliminated is an "aliasing" artifact;
- Figs. from 20 to 22 diagrammatically show an exemplary embodiment of the case shown in Figs. from 10 to 13, in which it is possible to use the method according to the invention, for eliminating the aliasing artifact.

### Description of the preferred exemplary embodiment

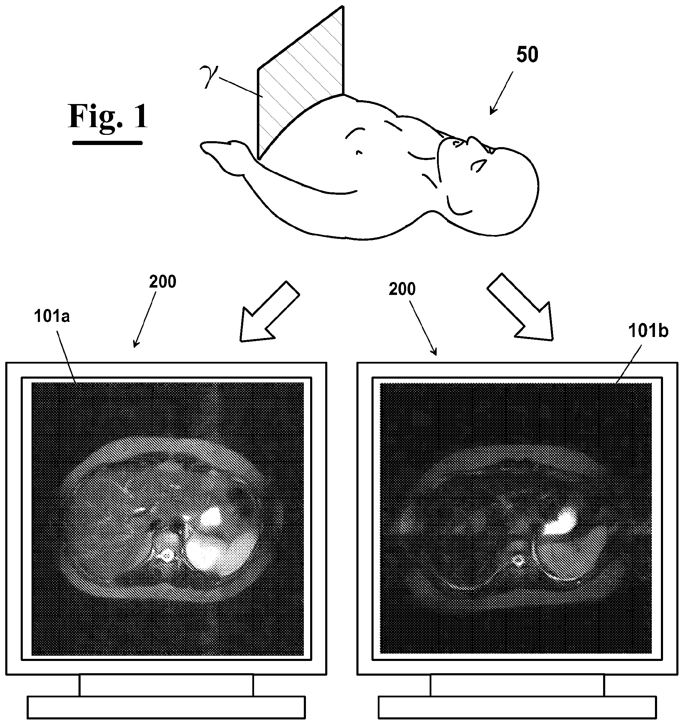

With reference to Fig. 1, the method according to the invention, for eliminating artifacts from an image, in particular a magnetic resonance image, begins with the steps of obtaining a first image 100a and a second image 100b. These are obtained at a same cross sectional plane y and through a same acquisition sequence using the same instrumental parameters of the machine such as the repetition time (TR), the echo time (TE), the inversion time (TI), the nutation angle (θ) or "flip angle", the size of the pixels, the Field Of View, or FOV, the layer thickness, the window (W), the level (L), with the first image 100a obtained using a phase coding along columns and the second image 100b obtained using a phase coding along rows.

If the anatomical part of interest is subject to a cardiac, or respiratory, movement, the acquisition of the sequence can be carried out in *"gate mode",* i.e. synchronizing the acquisition with an electrocardiogram or with a device for detecting the thoracic expansion due to the breath. This way, the image obtained by a phase coding along rows and the image obtained by a phase coding along columns correspond to different steps but the anatomical parts occupy the same position in the space.

In the example of Fig. 1, the images 100a and 100b are magnetic resonance images obtained for examining the health status of an anatomical part of a patient 50, e.g. the liver. However, the method according to the present invention can be also applied to magnetic resonance images of other type, such as magnetic resonance images obtained from animal beings, from vegetable species, from objects of other nature.

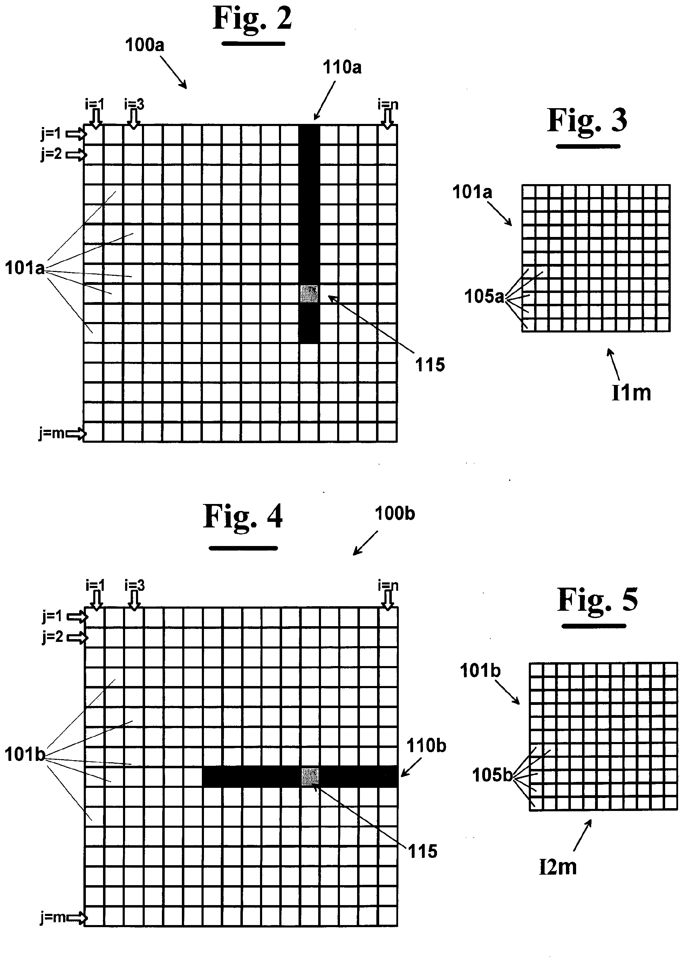

As diagrammatically shown in Figs. 2 and 4, the diagnostic images 100a and 100b thus obtained comprise a plurality of portions 101a and 101b, respectively, which are arranged in a matrix structure (m·n), i.e. comprising m rows and n columns. Each portion 101a, 101b, comprises a predetermined number of pixels 105a, and 105b, each of which has a determined intensity value i (Figs. 3 and 5).

More precisely, each portion 101a of the image 100a is associated with an intensity value *i*₁ₘ calculated, for example, making the arithmetic average of the intensity values i only of the pixels 105a that compose the portion. Similarly, each portion 101b of the image 100b is associated with an intensity value *i*₂ₘ, also this calculated, for example, doing the arithmetic average of the intensity values *i* of the pixels 105b that compose this.

The words "rows" and "columns" are to be interpreted in a broad sense, i.e. with such words can be also indicated the "strips" of portions of the image arranged along diagonal rows, or in any case along rows inclined at a determined angle with respect to a horizontal plane of the image. In case the situation that causes the exchange of the portions of the first image with those one of the second image occurs, the corresponding diagonal strips, or those one that are inclined at an angle with respect to a horizontal plane, exchange with each other.

As well known, the image 100a obtained by a phase coding along columns has at least one artifact 110a that mainly propagates along a direction substantially parallel to the columns and that involves one, or more, columns, and the image 100b, obtained by a phase coding along rows, has at least one artifact 110b that mainly propagates along a direction substantially parallel to the rows and that involves one, or more, rows.

In the considered case, the artifact derived from a phase coding 110a and 110b is produced by the pulsating movement of a blood vessel, and precisely of the aorta 115 of the patient.

Once obtained, the images 100a and 100b are subject to a primary processing sequence. This provides an analysis by columns of the images 100a and 100b that is carried out comparing the i^{th} column of the first image 100a with the i^{th} column of the second image 100b and calculating the number of different portions, i.e. having a different intensity average value (Iₘ₁≠Iₘ₂). With "intensity value" is intended an intensity value of signal, or an intensity value of colour, for example in gray scale. In the latter case the intensity value can be set between 0, corresponding to the black colour, and 255, corresponding to the white colour.

The data obtained as above disclosed are used for constructing a first derived image 100'b in which the columns of the image 100a are reproduced if the number of different portions 105'a and 105'b between the corresponding columns of the image 100a and of the image 100b is less than a predetermined threshold value *k₁,* with *k₁*=1...n. Instead, if the number of different portions 105'a and 105'b between the corresponding columns of the image 100a and of the image 100b is higher, or equal, to a predetermined threshold value *k₁,* with *k₁*=1...n, the corresponding column of the image 100'b is reproduced in the image 100b. The analysis by columns is then repeated for each i^{th} column of the first and second images 100a and 100b, obtaining a first derived image 100'b.

The images 100a and 100b are then subject to an analysis by rows that provides a comparison between the i^{th} row of the second image 100b and the i^{th} row of the first image 100b and calculating the number of different portions, i.e. having a different intensity average value (iₘ₁≠iₘ₂). The data so obtained are used for constructing a second derived image 100'a in which the rows of the image 100b are reproduced if the number of different portions 105'a and 105'b between the corresponding rows j is less than a predetermined threshold value *k₂*, with *k₂*=1...m. Instead, if the number of different portions 105'a and 105'b between the corresponding rows of the image 100a and of the image 100b is higher, or equal, to a predetermined threshold value *k₂*, with *k₂*=1...m, the corresponding row of the image 100a is reproduced in the image 100'a. The analysis by rows is then repeated for each j^{th} row of the first and second images 100a and 100b obtaining a second derived image 100'a.

The above disclosed comparison of corresponding columns, or rows, consisting of the comparison of the respective intensity values *i*ₘ₁ and *i*ₘ₂, is carried out considering a predetermined tolerance. More in detail, if the difference Δ*i* between the intensity values of two homologous portions 105a and 105b, i.e. occupying a same position in the images 100a and 100b, is less than a reference value Δ*i** then the intensity values of the two homologous portions 105a and 105b are considered to be equal to each other, if instead the difference between the intensity values of the two homologous portions is higher than the reference value Δi*, then the intensity values of the two homologous portions are considered to be different from each other. Reference value Δ*i** can be preliminarily chosen by the operator, or it can be a default value of the machine. In an exemplary embodiment of the invention, each portion 105 can comprise only one pixel and the numbers m of rows and n of columns can be selected from the group consisting of: 128, 256, 512, 1024 and 2048. In this case, the average values Iₘ₁ and Iₘ₂ of each portion 105a and 105b, respectively, coincide with the brightness value of the pixels that compose the portion 105a, or 105b.

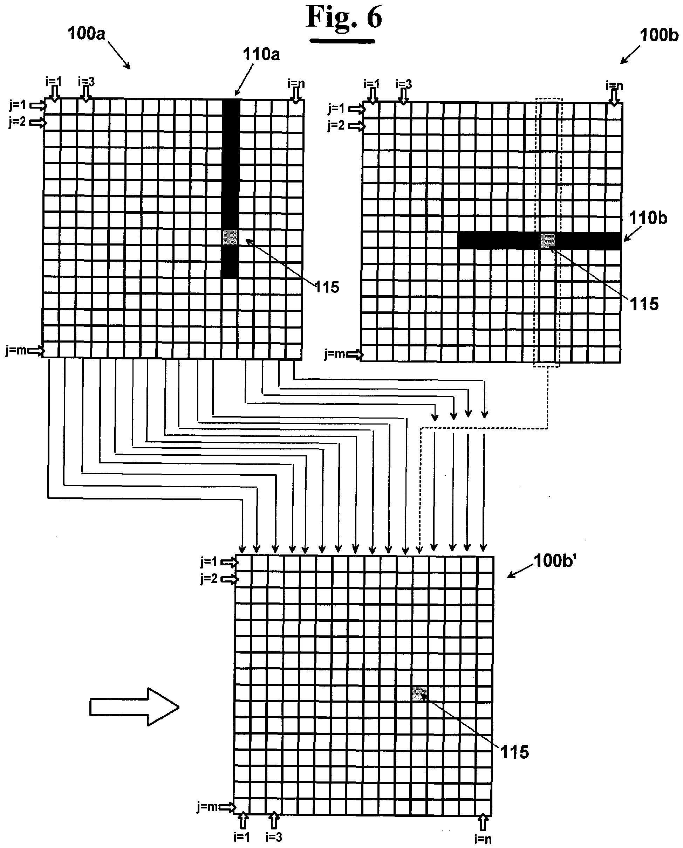

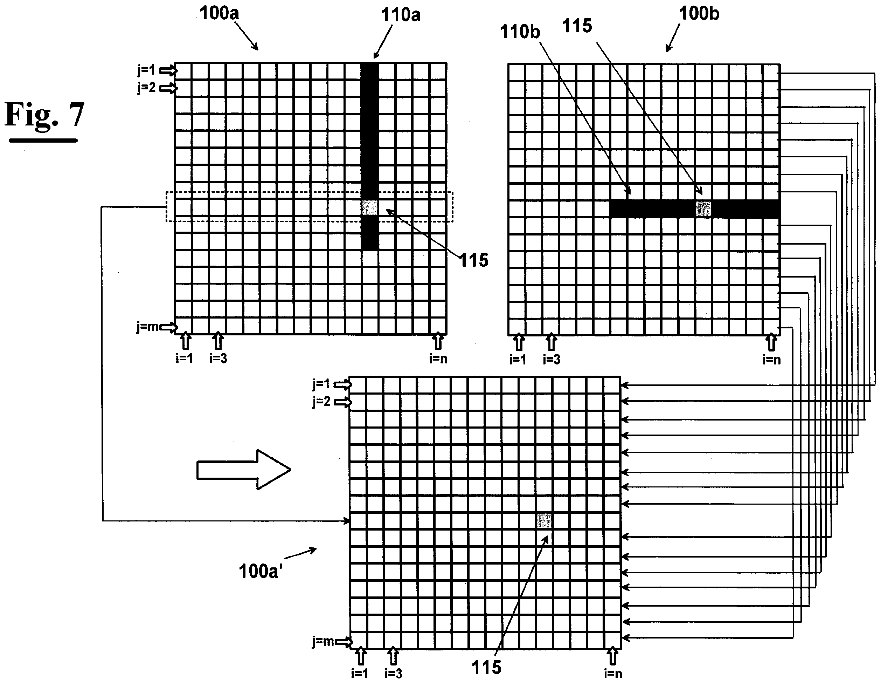

In the case shown in Figs. 6 and 7 the threshold value *k₁* and the threshold value *k₂* are chosen equal to the value 2. At the end of the comparison by columns and of the comparison by rows the two derived images 100'a and 100'b are identical and they have no artifacts. More precisely, only the portion 115 of the columns and of the rows having artifacts 110a and 110b is still present in the images 100a and 100b, respectively. This portion, which is located at the intersection between the column 110a of the image 100a and the row 110b of the image 100b corresponds to a blood vessel 115, i.e. to an anatomical part that is really present in the images.

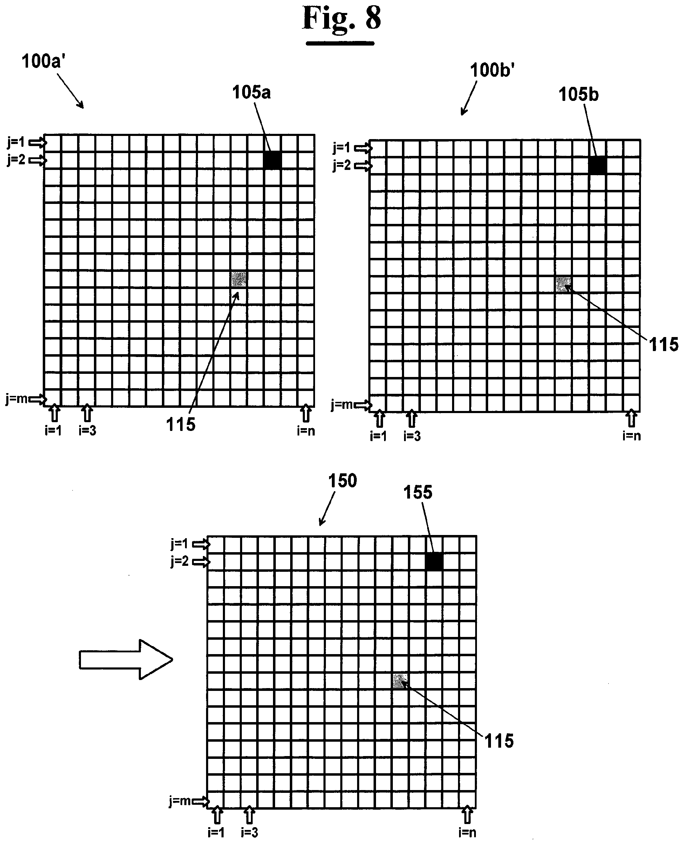

The method, as above described, allows to obtain a new image with respect to the starting image. The new image is selected from the group consisting of: the first derived image of I generation 100'a, the second derived image of I generation 100'b, or it is obtained by a combination thereof, image 150 (Fig. 8).

In case the two derived images 100'a and 100'b are not identical, it is possible to subject them to a following processing sequence. In this case, the image to be considered as basic image when applying the comparison by columns is the image 100'a (Fig. 7). Similarly, the image to be considered as basic image when applying the comparison by rows is the image 100'b (Fig. 6). Furthermore, the threshold values *k₁*' and *k₂*' to consider in the S comparison by rows and in the comparison by columns are reduced of one unit with respect to the previous processing sequence, i.e. *k₁'*=*k₁*-1 and *k₂'*=*k₂*-1. The processing step of the images stops when the threshold values *k₁* and *k₂* are equal to 0. Furthermore, the threshold value *k₁* used in the analysis by columns is preferably chosen equal to the threshold value *k₂* used in the analysis by rows, i.e. *k₁*=*k₂*=k*.* Normally, value k is set between 0 and the number of rows, or of columns of the image. In an exemplary embodiment k, instead, is selected from the group consisting of: 2 and the number of rows, or columns.

In a further exemplary embodiment, once obtained the final derived images, for example the images 100'a and 100'b, the average values are calculated of the intensity *i*ₘ* (=iₘ₁+iₘ₂/2) for each couple of homologous portions 105a and 105b, i.e. occupying a same position in the first derived image 100'b and in the second derived image 100'a. The average value im* so calculated is, then, associated with the portion 155 of a final image 150 successively constructed that occupies the same position of the couple of homologous portions 105'a and 105'b of the first and second derived images 100'b and 100'a. This further step has the purpose of further improving the definition of the final image 100'c.

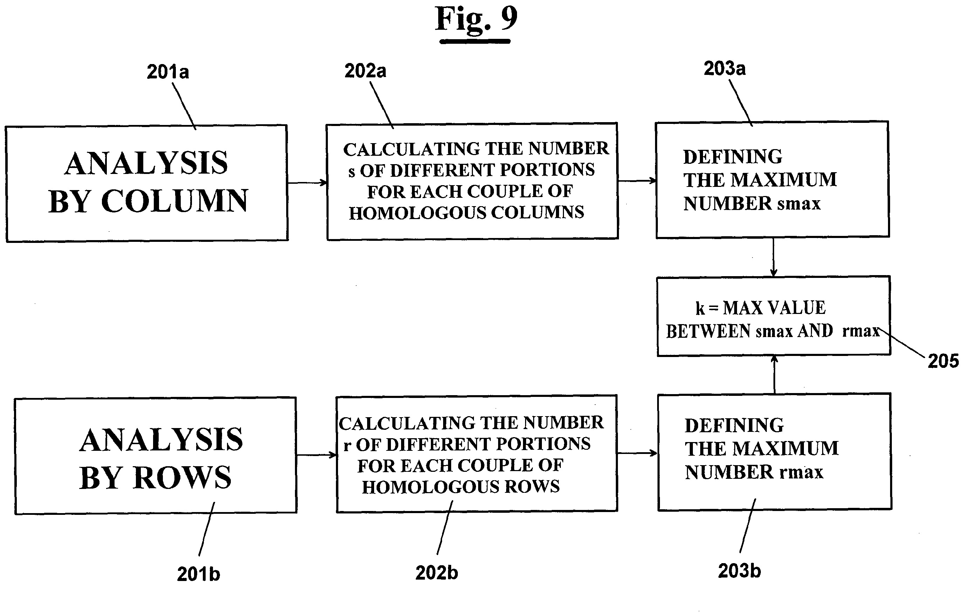

The threshold value k can be calculated as diagrammatically shown in Fig. 9 before subjecting the images 100a and 100b to the above described processing sequence. This procedure provides to subject the first and second images 100a and 100b to an analysis by columns, block 201a. For each couple of homologous columns the number s of different portions is then calculated, block 202a. Then, among all the values s a maximum number sₘₐₓ is defined, block 203a. Similarly, the images 100a and 100b are subject to an analysis by rows, block 201b. For each couple of homologous rows the number r of different portions, block 202b is then calculated. Then, among all the values r a maximum number *rₘₐₓ* is defined, block 203b. Finally, to the value k, with k=*k₁*=*k₂*, is associated the higher value between the calculated numbers *sₘₐₓ* and *rₘₐₓ,* block 205.

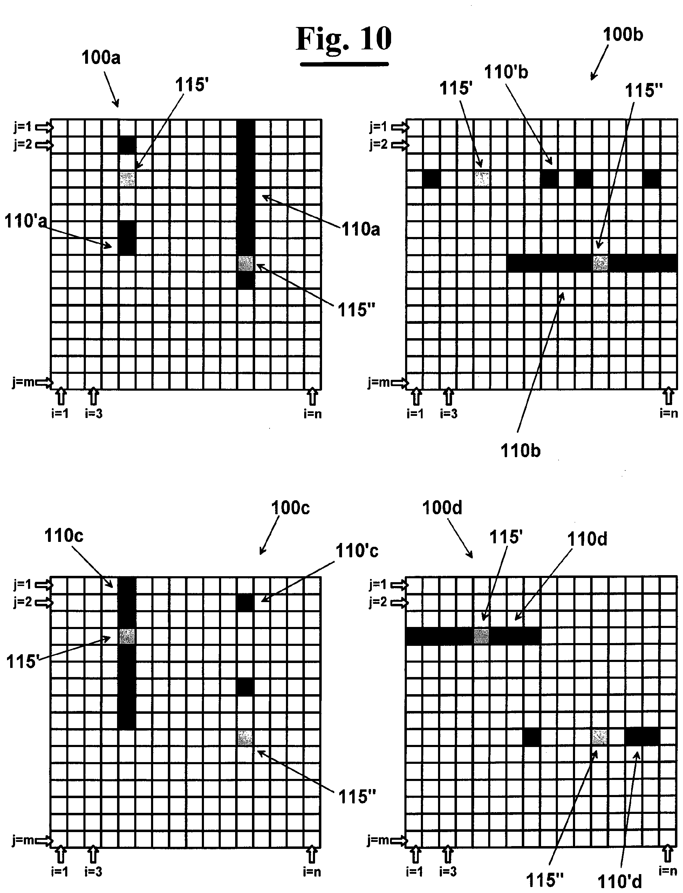

In an exemplary embodiment of the invention, as diagrammatically shown in Fig. 10, it is possible to start from four images 100a-100d obtained using a same acquisition sequence and the same instrumental parameters, but two images 100a and 100c using a phase coding along columns and the other two images 100b and 100d using a phase coding along rows. Therefore, in this case, there are two couples of images 100a,100b and 100c,100d each of which comprises an image 100a, or 100c, obtained using a phase coding along columns and an image 100b, or 100d, obtained using a phase coding along rows. Each image 100a-100d has at least one phase coding artifact that mainly propagates in a direction substantially parallel to the columns in case of images obtained by a phase coding along columns 100a and 100c, and along a direction substantially parallel to the rows in the images obtained by a phase coding along rows 100b and 100d. In the case of Fig. 10, each image 100a-100d has two phase coding artifacts, and precisely a first phase coding artifact 110a-110d for example generated by a first blood vessel 115' and a second phase coding artifact 110'a-110'd generated by a second blood vessel 115".

In this case, the method for eliminating the artifact from an image provides to subject to the above described steps each couple of images 100a-100b and 100c-100d. More precisely, through the processing of the first couple of images 100a-100b a first final image 150 is obtained and through the processing of the second couple of images a second final image 150' is obtained. The first and second final images 150 and 150' are in this case subject to a further step of computing the average value of the intensity i of the respective homologous portions. This way, a final image is obtained of the part of interest, for example a specific anatomical part, having a high definition. Normally, it is possible to subject to a processing sequence, as above described, a desired combination of the four starting images, provided that an image is obtained by a phase coding along rows and an image is obtained by a phase coding along columns.

As diagrammatically shown in Figs. from 11 to 15, the method according to the invention can be applied also to correct, or completely eliminate, an "aliasing" artifact, i.e. an artifact produced by a "reprojection" of parts of the image arranged outside the field of view, or FOV, of the image.

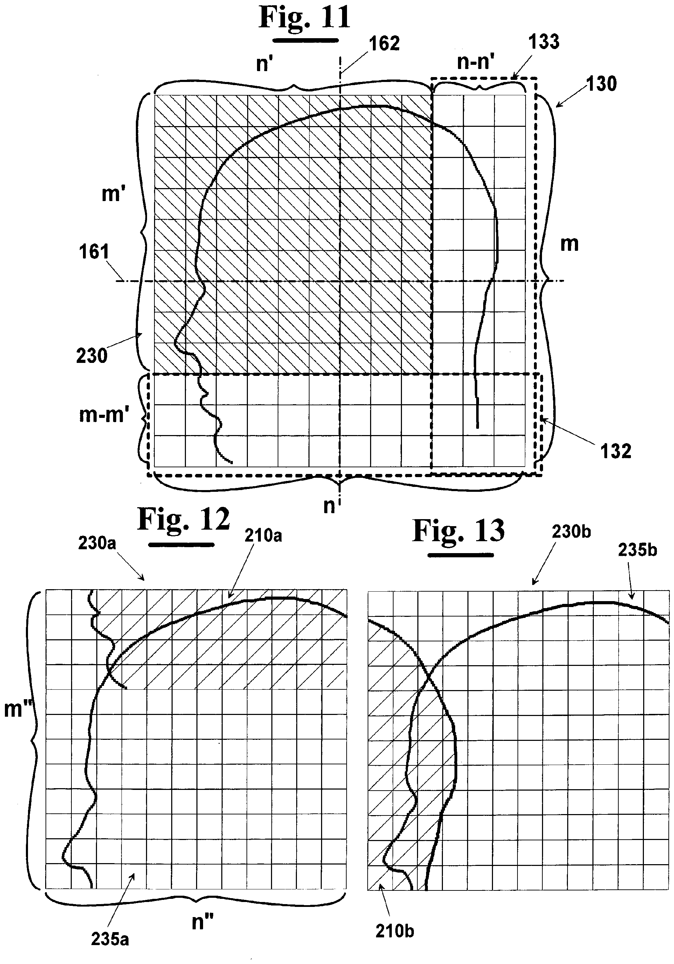

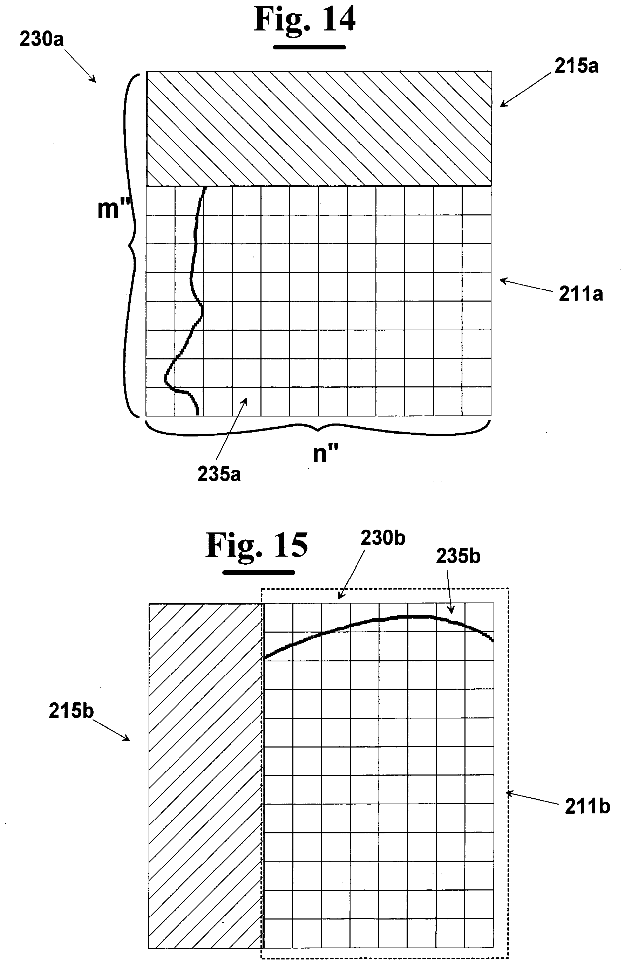

As shown for example in Fig. 11, the portions 132 and 133, not belonging to a predetermined region of interest 230 (hatched area of Fig. 11) of a reference image 130, or *"scout"* image, produce an artifact known as "aliasing" artifact. More precisely, in image 230a (Fig. 12) obtained by a phase coding along columns there is an artifact 210a caused by a reprojection of the rows not belonging to region of interest 230. Similarly, in image 230b obtained by a phase coding along rows (Fig. 13) there is an artifact 210b caused by a reprojection of the columns not belonging to region of interest 230.

In this case, the same steps are carried out as described with reference to Figs. from 3 to 7, but the final image 150 is obtained by applying a processing sequence in which, in the analysis by rows, the image obtained by a phase coding along columns, i.e. image 230a, is considered to be the basic image. More precisely, if the number of different portions, i.e. having different intensity values *i*, of two homologous rows of images 230a and 230b, is less than a predetermined threshold value k, the row of basic image 230a is reproduced in the derived image "as such". Instead, if the number of different portions of two homologous rows, i.e. having different intensity values *i*, is higher, or equal, to a predetermined threshold value k, is the corresponding row of image 230b to be reproduced in the derived image.

Similarly, in the analysis by columns the image obtained by a phase coding along rows, i.e. image 230b, is considered to be the basic image. More precisely, if the number of different portions of two homologous columns of images 230a and 230b, i.e. having different intensity values *i*, is less than a predetermined threshold value k, the column of basic image 230b is reproduced in the derived image as such. Instead, if the number of different portions of two homologous columns, i.e. having different intensity values *i*, is higher, or equal, to a predetermined threshold value k, the corresponding column of image 230a is reproduced in the derived image.

The above described process improves the quality of the image, reducing, or completely eliminating, aliasing artifacts. A similar process can be applied if the artifact present in the image is a "wrap around" artifact. This type of artifact is produced on the magnetic resonance image if an object is located outside the field of view, or FOV of the image.

Alternatively, the final image 150 can be obtained through a sequence of steps that provides a selection of a region of interest 230 in a reference image 130. Reference image 130 can be a "scout" image, or an image that has as requirements the vision of the whole surface without exclusions of anatomical parts, in other words the four sides of the image must be as much as possible tangential to the perimeter of the anatomic section, or the human figure must be perfectly inscribed in the image.

Normally, reference image 130 comprises a predetermined number of rows m and a predetermined number of columns n, the region of interest comprising a predetermined number of rows m', with m'<m, and a predetermined number of columns n', with n'<n. An acquisition step is then provided for obtaining a first image 230a of region of interest 230 by a phase coding along columns. Image 230a has a matrix structure (m"·n"), i.e. a plurality of portions 235a arranged on m" rows and n" columns. Each portion 235a has a determined intensity average value Iₘ₁. A step follows for obtaining a second image 230b of region of interest 230. Image 230b is obtained through the same acquisition sequence used for obtaining first image 230a, but using a phase coding along rows. Also image 230b comprises a plurality of portions 235b having a matrix structure (m"·n"), i.e. having m" rows and n" columns, each portion having a determined intensity value *i*m2. Then a computing step is provided for computing an enlargement factor "r" wherein r=m"/m'=n"/n'. Factor r, i.e an enlargement or zoom factor, is used for determining a first working area 211a on first image 230a. More in detail, the number of rows (m-m') of reference image 130 external to region of interest 230 is multiplied by enlargement factor r and it is provided, moreover, to exclude the number of rows r·(m-m') thus obtained from first image 230a. More precisely, from image 230a the r·(m-m') rows (hatched area 215a in Fig. 12) are excluded arranged in a symmetric position with respect to a horizontal axis 161 to the position that the rows 162 occupy in the reference image 130.

Similarly, a second working area 211b is defined in image 230b that is obtained multiplying the number of columns of the reference image external to the region of interest by enlargement factor r and excluding from image 230b the number of columns thus obtained. In this case the columns that are subtracted from image 230b are the columns that occupy the region of space 215b, i.e. the columns arranged in a symmetric position with respect to a vertical axis 162 to the position occupied in reference image 130 by the excluded columns 133.

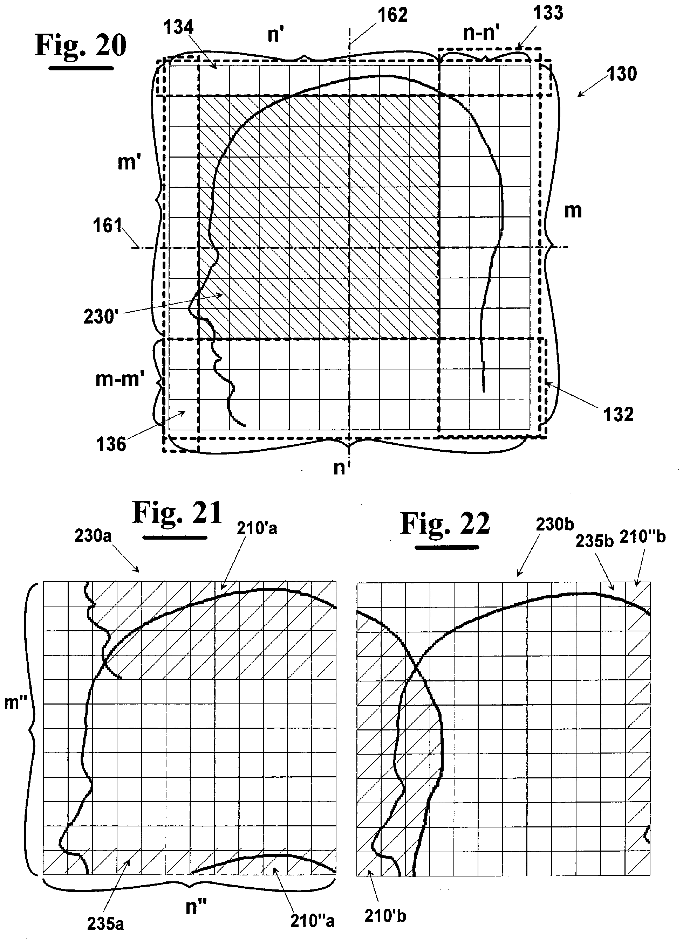

Normally, as shown in the embodiment shown in Figs. from 20 to 22, the rows 134 that in reference image 130 are excluded by region of interest 230' and are located above, are multiplied by the enlargement factor r and are then subtracted from first image 230a starting from below (hatched area 210"a in Fig. 21), and analogously the rows 132 that in reference image 130 are external to region of interest 230' and are located below are multiplied by the enlargement factor r and, then, subtracted from first image 230a starting from the above (hatched area 210'a in Fig. 21).

Similarly, the columns 133 that in reference image 130 are excluded from region of interest 230' and are located at the right side of the region of interest same, are multiplied by enlargement factor r and then are subtracted from second image 230b starting from the left side (hatched area 210"b of Fig. 22), whereas the columns 136 that in reference image 130 are excluded from region of interest 230' and are located at the left side of region of interest 230' are multiplied by enlargement factor r and then are subtracted from second image 230b starting from the right side (hatched area 210'b of Fig. 22) .

Returning now to the embodiment shown in Figs. from 11 to 13, once defined the first and second working areas 211a and 211b, it is possible to start the construction of a final image. In particular, first and second working areas 211a and 211b comprise a common region 238, comprising a plurality of homologous portions, i.e. occupying the same positions in the first and second images 230a and 230b, and one or more not-in-common regions 239a and 239b. Therefore, the portions of common region 238 are reproduced in the final image taking them from first image 230a, or from second image 230b.

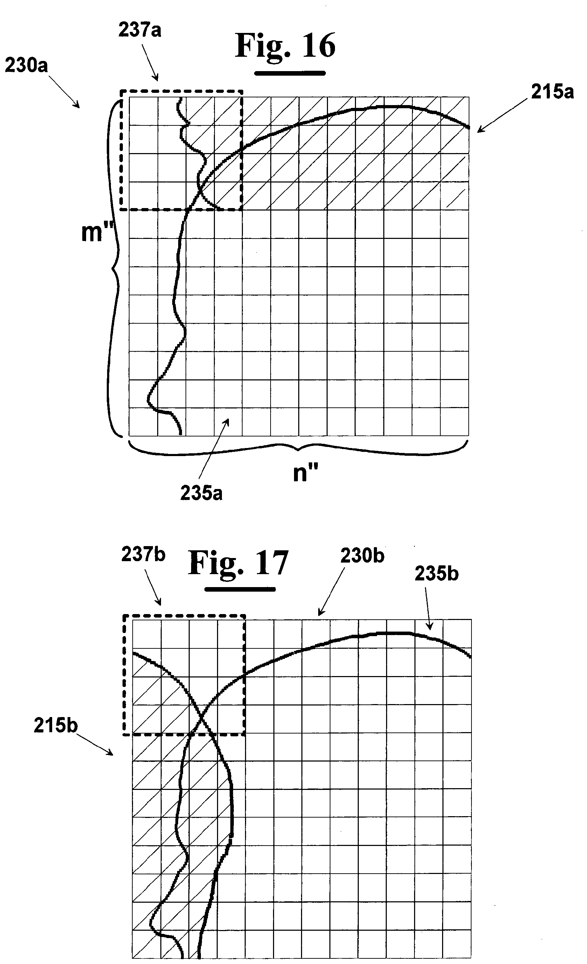

In first and second images 230a and 230b, then, at least one end region is defined that does not belong to the first working area or to the second working area either. In the case shown in Figs. 10-13 a single end region 237 is present, i.e. in image 230a the end region enclosed in a dashed rectangle 237a (Fig. 16) and in image 230b the end region enclosed in a dashed rectangle 237b (Fig. 17). The processing sequence above described with reference to Figs. from 11 to 13 is then applied to end regions 237a and 237b.

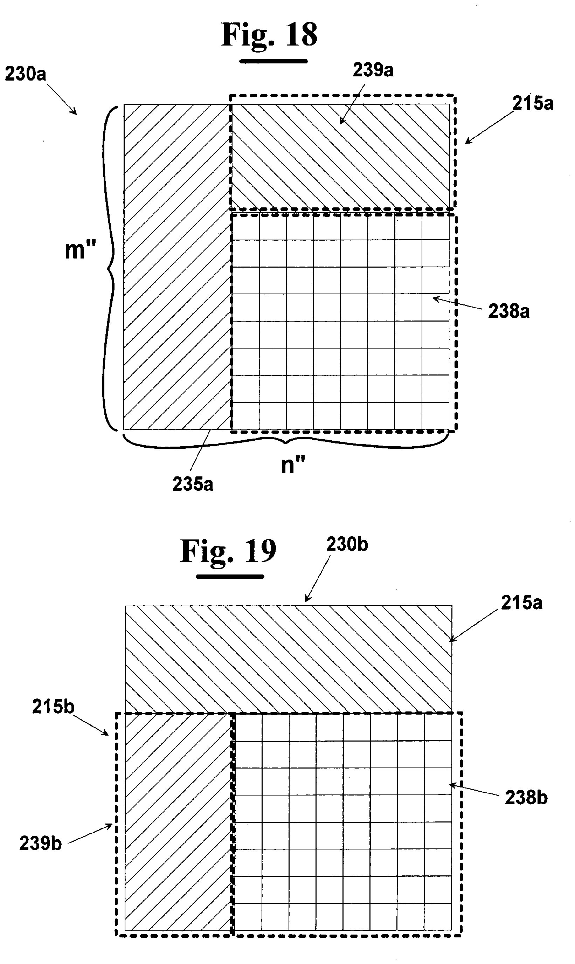

In a further exemplary embodiment it is possible to apply the above described primary processing sequence to intersection areas 238a and 238b of the first working area 211a with the second working area 211b defined in the first and second images 230a and 230b (Fig. 18 and 19).

All the different exemplary embodiments above described allow to eliminate phase coding artifacts from a magnetic resonance image, for example a diagnostic image. Therefore, the method according to the invention makes it possible to obtain an improved image from which to start and more reliable than those that are obtainable by the presently used techniques for reducing the effects of the artifacts due to a phase coding from a magnetic resonance image.

The foregoing description of specific embodiments will so fully reveal the invention according to the conceptual point of view, so that others, by applying current knowledge, will be able to modify and/or adapt for various applications such embodiments without further research and without departing from the invention, and it is therefore to be understood that such adaptations and modifications will have to be considered as equivalent to the specific embodiment. The means and the materials to realise the different functions described herein could have a different nature without, for this reason, departing from the field of the invention. It is to be understood that the phraseology or terminology employed herein is for the purpose of description and not of limitation.

## Claims

1. Method for eliminating artifacts (110) from a magnetic resonance image comprising the steps of:
- obtaining a first image (100a) through a predetermined data acquisition sequence and using a phase encoding direction along columns, said first image (100a) comprising a plurality of portions (101a), each portion (101a) arranged in a matrix structure of (m·n) pixels (105a) having m rows and n columns, each portion of said plurality being associated to a brightness intensity value *i₁* calculated making the arithmetic average, or the weighted average, of the intensity values of the pixels (105a) that compose said portion (101a);
- obtaining a second image (100b) through said data acquisition sequence used to obtain said first image (100a), but using a phase encoding direction along rows, said second image (100b) comprising a plurality of portions (101b), each portion (101b) arranged in a matrix structure of (m·n) pixels (105b) having m rows and n columns, each portion of said plurality being associated to a brightness intensity value *i₂* calculated making the arithmetic average, or the weighted average, of the brightness intensity values of the pixels (105b) that compose said portion (101b);
- applying a processing sequence to said first and to said second image (100a,100b), said processing sequence comprising the steps of:
- analysing by columns said first and second images (100a,100b), by a comparative analysis by columns of at least one column of said first image (100a) with a corresponding column of said second image (100b) and calculating, among said corresponding columns, the number of portions (101a,101b) having different brightness intensity values (*i*ᵢ≠*i*₂);
- creating a first derived image (100'b) obtained from one between said first and second images (100a,100b) replacing said, or each, column of said first or second image with the corresponding column of said second or first image if the number of portions having different brightness intensity values (*i*₁≠*i*₂), between said first and second images (100a,100b) for a respective analysed column, is higher, or equal, to a predetermined threshold value *k₁,* with *k₁*=1...n;
- repeating said step of analysing by columns for all the columns of said first and second images (100a,100b) obtaining a first derived image of I generation;
- analysing by rows said first and second images (100a,100b), by a comparative analysis by rows of at least one row of said second image with a corresponding row of said first image and calculating between said corresponding rows the number of portions having different brightness intensity values (iᵢ≠i₂);
- creating a second derived image (100'a) obtained from one between said second and said first image (100b,100a) replacing said, or each, row of said second or first image with the corresponding row of said first or second image, respectively, if the number of portions having different brightness intensity values between said first and second images, for a respective analysed row, is higher, or equal, to a predetermined threshold value *k₂*, with *k2*=1...m;
- repeating said analysis by rows for all the rows of said images, obtaining a second derived image of I generation;
- subjecting the first and the second derived image of I generation to a further processing step obtaining a first and a second derived image of II generation, said further processing step being carried out subjecting to an analysis by columns the derived image of I generation obtained by an analysis by rows, and to an analysis by rows the derived image of I generation obtained by an analysis by columns, and subtracting 1 from the threshold value k1, or k2, used during the previous step of comparative analysis carried out by rows, or by columns, using as threshold values k1'=k1-1 and k2'=k2-1, obtaining an improved image;
- said comparative analysis by columns and said comparative analysis by rows consisting in a comparison of the brightness intensity values of the respective portions occupying the same positions in said first and in said second image, said comparison of the brightness intensity values being carried out considering the brightness intensity values of the two respective portions to be equal if said difference of brightness intensity values of two respective portions is less than a predetermined reference value Δi*, and, instead, considering the brightness intensity values of the two portions to be different if said difference of brightness intensity values of the two respective portions is higher than the predetermined reference value Δi*.

2. Method, according to claim 1, wherein, furthermore, a step is provided of computing the difference between the brightness intensity values of the portions of a same row and of a same column and wherein if the difference of the brightness intensity values of at least two portions of a same row, or of a same column, of a same image is less than a predetermined threshold value Δiₗᵢₘ an additional control step is provided for verifying that it is not a portion of a row, or of a column, along which the artifact propagates.

3. Method, according to claim 1, or 2, wherein said reference value Δi* and/or said reference value Δi* ₗᵢₘ is selected from the group comprised of:
- a value preliminarily chosen by an operator;
- a default value.

4. Method, according to claim 1, wherein said threshold value *k₁* used for said step of analysing by columns coincides with said threshold value *k₂* used for said analysis by rows, i.e. *k₁*=*k₂*=k.

5. Method, according to claim 1, wherein said threshold value k is calculated through the steps of:
- analysing by columns said first and second images;
- computing a number s of portions having different brightness intensity values between at least one column of the first image and a corresponding column of the second image;
- defining a maximum number *smax* among all the different numbers s of all the couples of analysed columns;
- analysing by rows said first and second images;
- computing a number r of portions having different brightness intensity values between at least one row of the first image and a corresponding row of the second image;
- defining a maximum number *rmax* between all the different numbers r of all the couples of analysed rows;
- associating at said threshold value k the higher values between the calculated numbers *sₘₐₓ* and *rₘₐₓ.*

6. Method, according to claim 1, wherein in case of an artifact due to a reprojection, i.e. an "aliasing" artifact, said processing sequence comprises the steps of:
- analysing by columns said first and second images (100a,100b), by a comparative analysis by columns of at least one column of said first image with a corresponding column of said second image, and calculating the number of portions having a different brightness intensity value, between said corresponding columns;
- creating a first derived image obtained by said second image, by replacing said, or each, column of said second image with the corresponding column of said first image if the number of portions having different brightness intensity values, between said first and second images (100a,100b) for a respective analysed column, is higher, or equal, to a predetermined threshold value *k₁,* with *k₁*=1...n;
- repeating said step of analysing by columns for all the columns of said first and second images, obtaining a first derived image of I generation;
- analysing by rows said first and second images, by a comparative analysis by rows of at least one row of said second image with a corresponding row of said first image and calculating the number of portions having different brightness intensity values, between said corresponding rows;
- creating a second derived image obtained by said first image, by replacing said, or each, row of said first image (100a) with the corresponding row of said second image (100b) if the number of portions having different brightness intensity values, between said first and second images (100a,100b) for a respective analysed row, is higher, or equal, to a predetermined threshold value *k₂*, with *k2*=1...m;
- repeating said analysis by rows for all the rows of said images, obtaining a second derived image of I generation.

7. Method, according to any claim from 1 to 6, wherein said processing sequence is repeated until when at least one among said threshold value *k₁,* or *k₂*, used for carrying out said analysis by rows, or said analysis by columns, is equal to 0.

8. Method, according to claim 1, wherein said processing sequence is repeated until when both said threshold values *k₁* and *k₂* are equal to 0.

9. Method, according to claim 1, wherein four images are provided starting the anatomical part to analyse, said four images being obtained using a same data acquisition sequence and same instrumental variables for each image obtained and wherein two of said four images to analyse are obtained using a phase coding along rows and the other two using a phase coding along columns such that two couples of images are obtained each of which comprises an image obtained using a phase coding along rows and an image obtained using a phase coding along columns, to each couple of images said comparative analysis being applied by rows and said comparative analysis by columns such that through a control of said first couple of images a first improved image is obtained and through a control of said second couple of images a second improved image is obtained, wherein said first and said second improved images are subject to a further step of computing the average value of the brightness intensity of the respective portions, to obtain a final image of the anatomical part under examination have a high definition.

## Patentansprüche

1. Verfahren zum Entfernen von Artefakten (110) aus einem Magnetresonanzbild, das die folgenden Schritte umfasst:
- Erlangen eines ersten Bildes (100a) durch eine vorbestimmte Datenerfassungssequenz und Verwenden einer Phasenkodierungsrichtung entlang Spalten, wobei das erste Bild (100a) eine Vielzahl von Abschnitten (101a) umfasst, wobei jeder Abschnitt (101a) in einer Matrixstruktur von (m•n) Pixel (105a) mit m Zeilen und n Spalten angeordnet ist, wobei jeder Abschnitt der Vielzahl einem berechneten Helligkeitsintensitätswert *i₁* zugeordnet ist, der das arithmetische Mittel oder das gewichtete Mittel der Intensitätswerte der Pixel (105a), die den Abschnitt (101a) ausmachen, darstellt;
- Erlangen eines zweiten Bildes (100b) durch die zum Erlangen des ersten Bildes (100a) verwendete Datenerfassungssequenz, jedoch unter Verwendung einer Phasenkodierungsrichtung entlang Zeilen, wobei das zweite Bild (100b) eine Vielzahl von Abschnitten (101b) umfasst, wobei jeder Abschnitt (101b) in einer Matrixstruktur von (m•n) Pixel (105b) mit m Zeilen und n Spalten angeordnet ist, wobei jeder Abschnitt der Vielzahl einem berechneten Helligkeitsintensitätswert *i₂* zugeordnet ist, der das arithmetische Mittel oder das gewichtete Mittel der Helligkeitsintensitätswerte der Pixel (105b), die den Abschnitt (101b) ausmachen, darstellt;
- Anwenden einer Verarbeitungssequenz auf das erste und das zweite Bild (100a, 100b), wobei die Verarbeitungssequenz die folgenden Schritte umfasst:
- spaltenweises Analysieren des ersten und des zweiten Bildes (100a, 100b) mittels einer spaltenweisen Vergleichsanalyse mindestens einer Spalte des ersten Bildes (100a) mit einer entsprechenden Spalte des zweiten Bildes (100b) und Berechnen der Anzahl von Abschnitten (101a, 101b) mit unterschiedlichen Helligkeitsintensitätswerten (*i*₁≠*i*₂) bei den entsprechenden Spalten;
- Erzeugen eines ersten abgeleiteten Bildes (100'b), das aus einem von dem ersten und dem zweiten Bild (100a, 100b) erlangt wird, wobei die oder jede Spalte des ersten oder des zweiten Bildes mit der entsprechenden Spalte des zweiten oder des ersten Bildes ersetzt wird, wenn die Anzahl von Abschnitten mit unterschiedlichen Helligkeitsintensitätswerten (*i*₁≠*i*₂) zwischen dem ersten und dem zweiten Bild (100a, 100b) für eine jeweilige analysierte Spalte höher als oder gleich einem vorbestimmten Schwellenwert *k₁* ist, wobei *k₁*=1...n ist;
- Wiederholen des Schrittes des spaltenweisen Analysierens für alle Spalten des ersten und des zweiten Bildes (100a, 100b), wobei ein erstes abgeleitetes Bild einer I-Generation erlangt wird;
- zeilenweises Analysieren des ersten und des zweiten Bildes (100a, 100b) mittels einer zeilenweisen Vergleichsanalyse mindestens einer Zeile des zweiten Bildes mit einer entsprechenden Zeile des ersten Bildes und Berechnen der Anzahl von Abschnitten mit unterschiedlichen Helligkeitsintensitätswerten (*i₁*≠*i*₂) bei den entsprechenden Zeilen;
- Erzeugen eines zweiten abgeleiteten Bildes (100'a), das aus einem von dem zweiten und dem ersten Bild (100b, 100a) erlangt wird, wobei die oder jede Zeile des zweiten oder des ersten Bildes mit der entsprechenden Zeile des ersten bzw. des zweiten Bildes ersetzt wird, wenn die Anzahl von Abschnitten mit unterschiedlichen Helligkeitsintensitätswerten zwischen dem ersten und dem zweiten Bild für eine jeweilige analysierte Zeile höher als oder gleich einem vorbestimmten Schwellenwert *k₂* ist, wobei *k₂*=1...m ist;
- Wiederholen der zeilenweisen Analyse für alle Zeilen der Bilder, wobei ein zweites abgeleitetes Bild einer I-Generation erlangt wird;
- Unterziehen des ersten und des zweiten abgeleiteten Bildes der I-Generation einem weiteren Verarbeitungsschritt, wobei ein erstes und ein zweites abgeleitetes Bild einer II-Generation erlangt wird, wobei der weitere Verarbeitungsschritt ausgeführt wird, indem das durch eine zeilenweise Analyse erlangtes Bild der I-Generation einer spaltenweisen Analyse unterzogen wird und indem das durch eine spaltenweise Analyse erlangte abgeleitete Bild der I-Generation einer zeilenweisen Analyse unterzogen wird und indem 1 von dem Schwellenwert k1 oder k2, der während des vorhergehenden Schrittes der zeilenweise oder spaltenweise durchgeführten Vergleichsanalyse verwendet wurde, subtrahiert wird, wobei k1'=k1-1 und k2'=k2-1 als Schwellenwerte verwendet werden, wobei ein verbessertes Bild erlangt wird;
- wobei die spaltenweise Vergleichsanalyse und die zeilenweise Vergleichsanalyse aus einem Vergleich der Helligkeitsintensitätswerte der jeweiligen Abschnitte besteht, welche die gleichen Positionen in dem ersten und dem zweiten Bild belegen, wobei der Vergleich der Helligkeitsintensitätswerte ausgeführt wird, indem die Helligkeitsintensitätswerte der zwei jeweiligen Abschnitte als gleich angesehen werden, wenn die Differenz der Helligkeitsintensitätswerte von zwei jeweiligen Abschnitten geringer als ein vorbestimmter Referenzwert Δi* ist, und indem im Gegenzug die Helligkeitsintensitätswerte der zwei Abschnitte als unterschiedlich angesehen werden, wenn die Differenz der Helligkeitsintensitätswerte der zwei jeweiligen Abschnitte höher als der vorbestimmte Referenzwert Δi* ist.

2. Verfahren nach Anspruch 1, wobei außerdem ein Schritt zum Berechnen der Differenz zwischen den Helligkeitsintensitätswerten der Abschnitte einer gleichen Zeile und einer gleichen Spalte bereitgestellt ist, und wobei, wenn die Differenz der Helligkeitsintensitätswerte von mindestens zwei Abschnitten einer gleichen Zeile oder einer gleichen Spalte eines gleichen Bildes geringer als ein vorbestimmter Schwellenwert Δiₗᵢₘ ist, ein zusätzlicher Überprüfungsschritt bereitgestellt ist, um zu verifizieren, dass es sich dabei nicht um einem Abschnitt einer Zeile oder einer Spalte handelt, entlang dem sich das Artefakt ausbreitet.

3. Verfahren nach Anspruch 1 oder 2, wobei der Referenzwert Δi* * und/oder der Referenzwert Δi*ₗᵢₘ ausgewählt ist aus der Gruppe bestehend aus:
- einem Wert, der durch einen Bediener im Vorfeld ausgewählt wird;
- einem Standardwert.

4. Verfahren nach Anspruch 1, wobei der Schwellenwert *k₁,* der für den Schritt des spaltenweisen Analysierens mit dem Schwellenwert *k₂*, der für die zeilenweise Analyse verwendet wird, zusammenfällt, d. h. *k₁*=*k₂*=*k.*

5. Verfahren nach Anspruch 1, wobei der Schwellenwert k anhand der folgenden Schritte berechnet wird:
- spaltenweises Analysieren des ersten und des zweiten Bildes;
- Berechnen einer Anzahl s von Abschnitten mit unterschiedlichen Helligkeitsintensitätswerten zwischen mindestens einer Spalte des ersten Bildes und einer entsprechenden Spalte des zweiten Bildes;
- Definieren einer maximalen Anzahl *smax* unter allen unterschiedlichen Anzahlen s von allen Paaren der analysierten Spalten;
- zeilenweises Analysieren des ersten und des zweiten Bildes;
- Vergleichen einer Anzahl r von Abschnitten mit unterschiedlichen Helligkeitsintensitätswerten zwischen mindestens einer Zeile des ersten Bildes und einer entsprechenden Zeile des zweiten Bildes;
- Definieren einer maximalen Anzahl *rmax* unter allen unterschiedlichen Anzahlen r von allen Paaren der analysierten Zeilen;
- Zuordnen der höheren Werte unter den berechneten Anzahlen *sₘₐₓ* und *rₘₐₓ* an dem Schwellenwert k.

6. Verfahren nach Anspruch 1, wobei im Falle eines Artefakts aufgrund einer Neuprojektion, d. h. eines "Aliasing"-Artefakts, die Verarbeitungssequenz die folgenden Schritte umfasst:
- spaltenweises Analysieren des ersten und des zweiten Bildes (100a, 100b) mittels einer spaltenweisen Vergleichsanalyse mindestens einer Spalte des ersten Bildes mit einer entsprechenden Spalte des zweiten Bildes und Berechnen der Anzahl von Abschnitten mit einem unterschiedlichen Helligkeitsintensitätswert bei den entsprechenden Spalten;
- Erzeugen eines ersten abgeleiteten Bildes, das durch das zweite Bild erlangt wird, indem die oder jede Spalte des zweiten Bildes mit der entsprechenden Spalte des ersten Bildes ersetzt wird, wenn die Anzahl von Abschnitten mit unterschiedlichen Helligkeitsintensitätswerten zwischen dem ersten und dem zweiten Bild (100a, 100b) für eine jeweilige analysierte Spalte höher als oder gleich einem vorbestimmten Schwellenwert *k₁* ist, wobei *k₁*=1...n ist;
- Wiederholen des Schrittes des spaltenweisen Analysierens für alle Spalten des ersten und des zweiten Bildes, wobei ein erstes abgeleitetes Bild einer I-Generation erlangt wird;
- spaltenweises Analysieren des ersten und des zweiten Bildes mittels einer zeilenweisen Vergleichsanalyse mindestens einer Zeile des zweiten Bildes mit einer entsprechenden Zeile des ersten Bildes und Berechnen der Anzahl von Abschnitten mit unterschiedlichen Helligkeitsintensitätswerten bei den entsprechenden Zeilen;
- Erzeugen eines zweiten abgeleiteten Bildes, das durch das erste Bild erlangt wird, indem die oder jede Zeile des ersten Bildes (100a) mit der entsprechenden Zeile des zweiten Bildes (100b) ersetzt wird, wenn die Anzahl von Abschnitten mit unterschiedlichen Helligkeitsintensitätswerten zwischen dem ersten und dem zweiten Bild (100a, 100b) für eine jeweilige analysierte Zeile höher als oder gleich einem vorbestimmten Schwellenwert *k₂* ist, wobei *k₂*=1...m ist;
- Wiederholen der zeilenweisen Analyse für alle Zeilen der Bilder, wobei ein zweites abgeleitetes Bild einer I-Generation erlangt wird.

7. Verfahren nach einem der Ansprüche 1 bis 6, wobei die Verarbeitungssequenz solange wiederholt wird, bis mindestens einer des Schwellenwertes *k₁* oder *k₂*, die zum Ausführen der zeilenweisen Analyse oder der spaltenweisen Analyse verwendet werden, gleich 0 ist.

8. Verfahren nach Anspruch 1, wobei die Verarbeitungssequenz solange wiederholt wird, bis beide Schwellenwerte *k₁* und *k₂* gleich 0 sind.

9. Verfahren nach Anspruch 1, wobei vier Bilder zum Beginn der Analyse des anatomischen Teils bereitgestellt sind, wobei die vier Bilder unter Verwendung einer gleichen Datenerfassungssequenz und gleicher instrumenteller Variablen für jedes erlangte Bild erlangt werden und wobei zwei der zu analysierenden Bilder unter Verwendung einer Phasencodierung entlang Zeilen erlangt werden und die anderen zwei unter Verwendung einer Phasencodierung entlang Spalten erlangt werden, sodass zwei Paare von Bildern erlangt werden, von denen jedes ein Bild, das unter Verwendung einer Phasencodierung entlang Zeilen erlangt wurde, und ein Bild, das unter Verwendung einer Phasencodierung entlang Spalten erlangt wurde, umfasst, wobei auf jedes Paar von Bildern die zeilenweise Vergleichsanalyse und die spaltenweise Vergleichsanalyse angewendet werden, sodass mittels einer Kontrolle des ersten Paares von Bildern ein erstes verbessertes Bild erlangt wird und mittels einer Kontrolle des zweiten Paares von Bildern ein zweites verbessertes Bild erlangt wird, wobei das erste und das zweite verbesserte Bild einem weiteren Schritt des Berechnens des Mittelwertes der Helligkeitsintensität der jeweiligen Abschnitte unterzogen werden, um ein Endbild des untersuchten anatomischen Teils mit einer hohen Auflösung zu erlangen.

## Revendications

1. Procédé permettant d'éliminer des artéfacts (110) d'une image par résonance magnétique, comprenant les étapes de :
- obtention d'une première image (100a) par l'intermédiaire d'une séquence d'acquisition de données prédéfinie et en utilisant une direction de codage de phase le long de colonnes, ladite première image (100a) comprenant une pluralité de parties (101a), chaque partie (101a) étant agencée dans une structure de matrice de (m•n) pixels (105a) possédant m lignes et n colonnes, chaque partie de ladite pluralité étant associée à une valeur d'intensité de luminosité *i₁* calculée en effectuant la moyenne arithmétique, ou la moyenne pondérée, des valeurs d'intensité des pixels (105a) qui composent ladite partie (101a) ;
- obtention d'une seconde image (100b) par l'intermédiaire de ladite séquence d'acquisition de données utilisée pour obtenir ladite première image (100a), mais en utilisant une direction de codage de phase le long de rangées, ladite seconde image (100b) comprenant une pluralité de parties (101b), chaque partie (101b) étant agencée dans une structure de matrice de (m•n) pixels (105b) possédant m lignes et n colonnes, chaque partie de ladite pluralité étant associée à une valeur d'intensité de luminosité *i₂* calculée en effectuant la moyenne arithmétique ou la moyenne pondérée des valeurs d'intensité de luminosité des pixels (105b) qui composent ladite partie (101b) ;
- application d'une séquence de traitement à ladite première image et à ladite seconde image (100a, 100b), ladite séquence de traitement comprenant les étapes de :
- analyse par colonnes desdites première et seconde images (100a, 100b), par une analyse comparative par colonnes d'au moins une colonne de ladite première image (100a) avec une colonne correspondante de ladite seconde image (100b) et le calcul, parmi lesdites colonnes correspondantes, du nombre de parties (101a, 101b) possédant différentes valeurs d'intensité de luminosité (*i*₁≠*i*₂) ;
- création d'une première image dérivée (100'b) obtenue à partir d'une image parmi lesdites première et seconde images (100a, 100b) en remplaçant ladite colonne ou chaque colonne de ladite première ou de ladite seconde image par la colonne correspondante de ladite seconde ou de ladite première image si le nombre de parties possédant des valeurs d'intensité de luminosité différentes (*i*₁≠*i*₂), entre lesdites première et seconde images (100a, 100b) pour une colonne analysée respective, est supérieur ou égal à une valeur seuil prédéfinie *k₁,* avec *k₁*= 1...n ;
- répétition de ladite étape d'analyse par colonnes de toutes les colonnes desdites première et seconde images (100a, 100b) obtenant une première image dérivée de génération I ;
- analyse par lignes desdites première et seconde images (100a, 100b), par une analyse comparative par lignes d'au moins une ligne de ladite seconde image avec une ligne correspondante de ladite première image et le calcul entre lesdites lignes correspondantes du nombre de parties possédant différentes valeurs d'intensité de luminosité (*i*₁≠*i*₂) ;
- création d'une seconde image dérivée (100'a) obtenue à partir d'une parmi ladite seconde et ladite première image (100b, 100a) en remplaçant ladite ligne ou chaque ligne de ladite seconde ou de ladite première image par la ligne correspondante de ladite première ou de ladite seconde image, respectivement, si le nombre de parties possédant des valeurs d'intensité de luminosité différentes entre lesdites première et seconde images, pour une ligne analysée respective, est supérieur ou égal à une valeur seuil prédéfinie *k₂*, avec *k₂*= 1.....m ;
- répétition de ladite analyse par lignes pour toutes les lignes desdites images, obtenant une seconde image dérivée de génération I ;
- soumission de la première et de la seconde image dérivée de génération I à une autre étape de traitement, obtenant une première et une seconde image dérivée de génération II, ladite étape de traitement supplémentaire étant réalisée en soumettant à l'analyse par colonnes l'image dérivée de génération I obtenue par l'analyse par lignes, et à l'analyse par lignes, l'image dérivée de la génération I obtenue par l'analyse par colonnes et en soustrayant 1 de la valeur seuil k1, ou k2, utilisée durant l'étape précédente d'analyse comparative effectuée par lignes, ou par colonnes en utilisant en tant que valeurs seuil k1'=k1-1 et k2'=k2-1, obtenant une image améliorée ;
- ladite analyse comparative par colonnes et ladite analyse comparative par lignes consistant en une comparaison des valeurs d'intensité de luminosité des parties respectives occupant les mêmes positions dans ladite première image et dans ladite seconde image, ladite comparaison des valeurs d'intensité de luminosité étant effectuée en considérant que les valeurs d'intensité de luminosité des deux parties respectives doivent être égales si ladite différence de valeurs d'intensité de luminosité de deux parties respectives est inférieure à une valeur de référence prédéfinie Δi* et, au lieu de cela, en considérant que les valeurs d'intensité de luminosité des deux parties doivent être différentes si ladite différence des valeurs d'intensité de luminosité des deux parties respectives est supérieure à la valeur de référence prédéfinie Δi*.

2. Procédé selon la revendication 1, de plus, une étape de calcul de la différence entre les valeurs d'intensité de luminosité des parties d'une même ligne et d'une même colonne étant prévue et si la différence des valeurs d'intensité de luminosité d'au moins deux des parties d'une même ligne, ou d'une même colonne, d'une même image est inférieure à une valeur seuil prédéfinie Δiₗᵢₘ, une étape de vérification additionnelle étant prévue pour vérifier qu'une partie de la ligne ou qu'une partie de la colonne n'est pas celle selon laquelle l'artéfact se propage.

3. Procédé selon la revendication 1 ou 2, ladite valeur de référence Δi* * et/ou ladite valeur de référence Δi*ₗᵢₘ étant sélectionnée parmi le groupe comprenant :
- une valeur choisie au préalable par un opérateur ;
- une valeur par défaut.

4. Procédé selon la revendication 1, ladite valeur seuil *k₁* utilisée pour ladite étape d'analyse par colonnes coïncidant avec ladite valeur seuil *k₂* utilisée pour ladite analyse par lignes, c'est-à-dire *k₁*=*k₂*=*k.*

5. Procédé selon la revendication 1, ladite valeur seuil k étant calculée par les étapes de :
- analyse par colonnes desdites première et seconde images ;
- calcul d'un nombre *s* de parties possédant des valeurs d'intensité de luminosité différentes entre au moins une colonne de la première image et une colonne correspondante de la seconde image ;
- définition d'un nombre maximal *smax* parmi tous les nombres différents *s* de toutes les paires de colonnes analysées ;
- analyse par rangées desdites première et seconde images ;
- calcul d'un nombre r de parties possédant des valeurs d'intensité de luminosité différentes entre au moins une ligne de la première image et une ligne correspondante de la seconde image ;
- définition d'un nombre maximal *rmax* entre tous les différents nombres r de toutes les paires de lignes analysées ;
- association à ladite valeur seuil k des valeurs les plus élevées parmi les nombres calculés *sₘₐₓ* et *rₘₐₓ.*

6. Procédé selon la revendication 1, dans le cas d'un artéfact dû à une re-projection, c'est-à-dire un artéfact « de repliement de spectre », ladite séquence de traitement comprenant les étapes de :
- analyse par colonnes desdites première et seconde images (100a, 100b), par une analyse comparative par colonnes d'au moins une colonne de ladite première image avec une colonne correspondante de ladite seconde image, et calcul du nombre de parties possédant une valeur d'intensité de luminosité différente, entre lesdites colonnes correspondantes ;
- création d'une première image dérivée obtenue par ladite seconde image, en remplaçant ladite colonne, ou chaque colonne, de ladite seconde image par la colonne correspondante de ladite première image si le nombre de parties possédant des valeurs d'intensité de luminosité différentes, entre lesdites première et seconde images (100a, 100b) pour une colonne analysée respective, est supérieur ou égal à une valeur seuil prédéfinie *k₁,* avec *k₁*=1*...* n ;
- répétition de ladite étape d'analyse par colonnes pour toutes les colonnes desdites première et seconde images, obtenant une première image dérivée de génération I ;
- analyse par lignes desdites première et seconde images, par une analyse comparative par lignes d'au moins une ligne de ladite seconde image avec une ligne correspondante de ladite première image et calcul du nombre de parties possédant des valeurs d'intensité de luminosité différentes entre lesdites lignes correspondantes ;
- création d'une seconde image dérivée obtenue par ladite première image, en remplaçant ladite ligne, ou chaque ligne, de ladite première image (100a) par la ligne correspondante de ladite seconde image (100b) si le nombre de parties possédant des valeurs d'intensité de luminosité différentes, entre lesdites première et seconde images (100a, 100b) pour une ligne analysée respective est supérieur ou égal à une valeur seuil prédéfinie *k₂*, avec *k₂*=1....m;
- répétition de ladite analyse par lignes pour toutes les lignes desdites images, obtenant une seconde image dérivée de la génération I.

7. Procédé selon l'une quelconque des revendications 1 à 6, ladite séquence de traitement étant répétée jusqu'à ce qu'au moins l'une parmi ladite valeur seuil *k₁* ou *k₂*, utilisée pour réaliser ladite analyse par lignes, ou ladite analyse par colonnes, soit égale à 0.

8. Procédé selon la revendication 1, ladite séquence de traitement étant répétée jusqu'à ce que lesdites valeurs seuil *k₁* et *k₂* soient égales à 0.

9. Procédé selon la revendication 1, quatre images étant fournies commençant la partie anatomique à analyser, lesdites quatre images étant obtenues en utilisant la même séquence d'acquisition de données et les mêmes variables liées aux instruments pour chaque image obtenue et deux desdites quatre images à analyser étant obtenues à l'aide d'un codage de phase le long de lignes et les deux autres à l'aide d'un codage de phase le long de colonnes de sorte que deux paires d'images soient obtenues, chacune d'entre elles comprenant une image obtenue à l'aide d'une phase de codage le long de lignes et une image obtenue à l'aide d'un codage de phase le long des colonnes, à chaque paire d'images étant appliquée ladite analyse comparative par lignes et ladite analyse comparative par colonnes de sorte qu'à travers une commande de ladite première paire d'images une première image améliorée est obtenue et à travers une commande de ladite seconde paires d'images une seconde image améliorée est obtenue, lesdites première et seconde secondes images améliorées étant soumises à une étape supplémentaire de calcul de la valeur moyenne de l'intensité de luminosité des parties respectives, pour obtenir une image finale de la partie anatomique en cours d'examen présentant une haute définition.
